# EUROPEAN PATENT APPLICATION

(11) **EP 4 571 897 A1**
(43) Date of publication of application: **18.06.2025**
(21) Application number: 23914089.0
(22) Date of filing: 06.01.2023
(51) Int. Cl.: H01M 4/66, H01M 4/13, H01M 10/0525

(54) **NEGATIVE ELECTRODE CURRENT COLLECTOR AND PREPARATION METHOD THEREFOR, NEGATIVE ELECTRODE SHEET, SECONDARY BATTERY AND ELECTRIC DEVICE**

(71) Applicant: Contemporary Amperex Technology (Hong Kong) Limited, Central (HK)
(72) Inventor: MA, Li, Ningde Fujian 352100 (CN); GUAN, Wenhao, Ningde Fujian 352100 (CN); GE, Xiaoming, Ningde Fujian 352100 (CN)
(74) Representative: Ziebig Hengelhaupt Intellectual Property Attorneys Patentanwaltskanzlei PartGmbB
(86) International application number: PCT/CN2023/071068
(87) International publication number: WO 2024/145932

(57) **Abstract**

The present application provides a negative current collector. The negative current collector includes a substrate and a lithium alloy, where the lithium alloy is disposed on a surface of the substrate, and the lithium alloy includes lithium and a matrix material, an atomic ratio of lithium in the lithium alloy is 30% to 50%, and a plating amount of the lithium alloy is 2 /m² to 3 /m². The present application also provides a preparation method of the above-mentioned negative current collector, a positive electrode plate, a secondary battery and an electrical device. In the negative current collector provided by the present application, the lithium alloy is disposed on a surface of the negative current collector, where the atomic ratio of lithium in the lithium alloy is 30% to 50%, and the plating amount of the lithium alloy is 2 g/m² to 3 g/m². During the charging process of the secondary battery, lithium atoms can be oxidized into lithium ions and enter an electrolyte solution to supplement lithium consumed for forming a solid electrolyte interphase (SEI) on a negative electrode of a lithium-ion battery, which helps to improve the quality of the SEI, thereby improving an first-cycle Coulombic efficiency of the secondary battery.

## Description

### TECHNICAL FIELD

The present application relates to the technical field of batteries, in particular to a negative current collector and a preparation method thereof, a negative electrode plate, a secondary battery, and an electrical device.

### BACKGROUND

A secondary battery can enhance the power endurance of batteries, greatly improve the economic benefits of power storage, and promote the upgrading and transformation of consumer electronics, making itself be of great significance for human life. The use of lithium alloys is one of the effective methods to improve the first-cycle Coulombic efficiency of the secondary battery. However, existing lithium alloys are generally lithium sheets, lithium powders, lithium oxides or other metal oxide composites, among which lithium metal or lithium powders are very active and difficult to store, and bring high safety risks; and when lithium oxides and other metal oxide composites are used to make lithium alloys, the oxides have poor conductivity and contain a large proportion of inactive components.

Therefore, how to propose a negative current collector and a preparation method thereof, a negative electrode plate, a secondary battery, and an electrical device to improve the first-cycle Coulombic efficiency of the secondary battery is a problem that needs to be solved urgently.

### SUMMARY

In view of the above problems, the present application provides a negative current collector and a preparation method thereof, a negative electrode plate, a secondary battery, and an electrical device to improve the first-cycle Coulombic efficiency of the secondary battery.

In a first aspect, the present application provides a negative current collector, including a substrate and a lithium alloy, where the lithium alloy is disposed on a surface of the substrate, and the lithium alloy includes lithium and a matrix material, an atomic ratio of lithium in the lithium alloy is 30% to 50%, and a plating amount of the lithium alloy is 2 g/m² to 3 g/m².

In the technical solution of the embodiment of the present application, a lithium alloy is disposed on the surface of a substrate, the atomic ratio of lithium in the lithium alloy is 30% to 50%, and the plating amount of the lithium alloy is 2 g/m² to 3 g/m². During the charging process of the secondary battery, lithium atoms can be oxidized into lithium ions and enter an electrolyte solution to supplement the lithium consumed for forming a solid electrolyte interphase (SEI) on a negative electrode of a lithium-ion battery, which helps to improve the quality of the SEI, thereby improving the first-cycle Coulombic efficiency of the secondary battery.

Moreover, the matrix material left after the lithium alloy is dealloyed can effectively increase the active sites for lithium deposition, reduce the nucleation overpotential of lithium, reduce the local nucleation of lithium, and reduce the formation of lithium dendrites, therebyimproving the safety performance of the secondary battery.

At the same time, compared with a pure lithium metal, lithium alloys are more stable in air, which makes the performance of the secondary battery more stable.

In some embodiments, the matrix material includes at least one of Sn, Mg, Zn, Bi, Pb, Au, Ag, Al, and Si.

In the technical solution of the embodiments of the present application, the matrix material includes at least one of Sn, Mg, Zn, Bi, Pb, Au, Ag, Al, and Si. Sn, Mg, Zn, Bi, Pb, Au, Ag, and Al have good conductivity, which helps to reduce the impedance of the secondary battery and improve the first-cycle Coulombic efficiency of the secondary battery.

At the same time, when the active lithium in the secondary battery is insufficient, the lithium in the lithium alloy is used to supplement the secondary battery. Since Sn, Mg, Zn, Bi, Pb, Au, Ag, Al, and Si all have good lithiophilicity, after the lithium in the lithium alloy enters the electrolyte solution, a matrix material with good lithiophilicity is left, which can effectively increase the active sites for lithium deposition, reduce the nucleation overpotential of lithium, reduce the local nucleation of lithium, and reduce the formation of lithium dendrites, thereby improving the safety performance of the secondary battery.

In some embodiments, the matrix material is at least one of Sn, Mg, and Zn.

In the technical solution of the embodiment of the present application, since the matrix materials Sn, Mg, and Zn have a stable structure, the matrix materials are less prone to collapse after delithiation, thereby improving the structural stability of the secondary battery.

In some embodiments, the substrate is of a porous structure, a pore size of pores of the porous structure is 5 microns to 500 microns, and the porosity of the pores of the porous structure is 30% to 70%.

In the technical solution of the embodiment of the present application, by adopting a substrate with a porous structure, and setting the pore size and porosity to be within the above ranges, the adhesion of the lithium alloy on the surface of the substrate can be improved, thereby improving the stability of the secondary battery.

In some embodiments, the substrate is foamed copper or dealloyed porous copper.

In the technical solution of the embodiment of the present application, by using foamed copper or dealloyed porous copper, the adhesion of the lithium alloy on the surface of the substrate can be improved, thereby improving the stability of the secondary battery.

In some embodiments, the substrate is a copper foil.

In the technical solution of the embodiment of the present application, a copper foil is used, and the surface of the copper foil is highly smooth and easy to clean, thereby reducing the difficulty of the process.

In a second aspect, the present application provides a preparation method of the negative current collector according to any one of the above embodiments, the method including the following steps:
providing a substrate;
plating a matrix material on a surface of the substrate through a matrix material target, and plating a lithium metal on a surface of the matrix material through a lithium target to form an intermediate product, where an atomic ratio of lithium in the matrix material and the lithium metal is 30% to 50%, and a plating amount of the lithium alloy is 2 g/m² to 3 g/m²; and
conducting heat treatment on the intermediate product to form a lithium alloy from the matrix material and the lithium metal.

In the technical solution of the embodiment of the present application, a matrix material is plated on a surface of a substrate through a matrix material target, and a lithium metal is plated on a surface of the matrix material through a lithium target to form an intermediate product, where an atomic ratio of lithium in the matrix material and the lithium metal is 30% to 50%, and a plating amount of the lithium alloy is 2 g/m² to 3 g/m²; and heat treatment is conducted on the intermediate product to form a lithium alloy from the matrix material and the lithium metal, so as to prepare a negative current collector. During the charging process of a secondary battery, lithium atoms can be oxidized into lithium ions and enter an electrolyte solution to supplement the lithium consumed for forming an SEI on a negative electrode of a lithium-ion battery, which helps to improve the quality of the SEI, thereby improving the first-cycle Coulombic efficiency of the secondary battery.

In a third aspect, the present application provides a preparation method of the negative current collector according to any one of the above embodiments, the method including the following steps:
providing a substrate;
plating a lithium alloy on a surface of the substrate through a lithium alloy target, where the lithium alloy includes lithium and a matrix material. An atomic ratio of lithium in the lithium alloy is 30% to 50%, and a plating amount of the lithium alloy is 2 g/m² to 3 g/m².

In the technical solution of the embodiment of the present application, the lithium alloy is plated on the surface of the substrate through the lithium alloy target, where the lithium alloy includes lithium and a matrix material, the atomic ratio of lithium in the lithium alloy is 30% to 50%, and the plating amount of the lithium alloy is 2 g/m² to 3 g/m², so that a negative current collector is prepared. During the charging process of a secondary battery, lithium atoms can be oxidized into lithium ions and enter an electrolyte solution to supplement the lithium consumed for forming an SEI on a negative electrode of a lithium-ion battery, which helps to improve the quality of the SEI, thereby improving the first-cycle Coulombic efficiency of the secondary battery.

In a fourth aspect, the present application provides a negative electrode plate, including the negative current collector as described above or the negative current collector prepared by the preparation method of the negative current collector as described above, so as to improve the first-cycle Coulombic efficiency of the secondary battery.

In a fifth aspect, the present application provides a secondary battery, including the negative electrode plate as described above, to obtain a secondary battery with excellent first-cycle Coulombic efficiency.

In a sixth aspect, the present application provides an electrical device, including the secondary battery as described above.

The foregoing description is merely an overview of the technical solutions of the present application. The following describes specific embodiments of the present application illustratively to enable a clearer understanding of the technical solutions of the present application, enable embodiment of the technical solutions based on the content of the specification, and make the foregoing and other objectives, features, and advantages of the present application more evident and comprehensible.

### BRIEF DESCRIPTION OF DRAWINGS

To describe the technical solutions of some embodiments of the present application more clearly, the following outlines the drawings used in the embodiments of the present application. Evidently, the drawings outlined below are merely a part of embodiments of the present application. A person of ordinary skill in the art may derive other drawings from the outlined drawings without making any creative efforts.
FIG. 1 is a schematic diagram of alloying/dealloying potentials of lithium alloys in the related art.
FIG. 2 is a schematic structural diagram of an electrical device according to some embodiments of the present application;
FIG. 3 is a schematic exploded view of a battery according to some embodiments of the present application;
FIG. 4 is a schematic exploded view of a battery cell according to some embodiments of the present application;
FIG. 5 is a schematic diagram of discharge platforms and theoretical energy densities of lithium alloys of a negative current collector in the related art.

The drawings are not drawn to actual scale.

Reference Numerals: Electrical device 1000;
battery 100, controller 200, motor 300;
box 10, first portion 11, second portion 12;
battery cell 20, end cap 21, electrode terminal 21a, housing 22, cell assembly 23, tab 23a, and functional component 24.

### DETAILED DESCRIPTION OF EMBODIMENTS

Embodiments of the technical solution of the present application are described in detail below in conjunction with the accompanying drawings. The following embodiments are only used to more clearly illustrate the technical solution of the present application, and therefore, are merely examples and cannot be used to limit the protection scope of the present application.

Unless otherwise defined, all technical and scientific terms used herein bear the same meanings as what is normally understood by a person skilled in the technical field of the present application. The terms used herein are merely intended to describe specific embodiments but not to limit the present application. The terms "include" and "contain" and any variations thereof used in the specification, claims, and brief description of drawings of the present application are intended as non-exclusive inclusion.

In the description of the embodiments of the present application, the terms "first", "second", and the like are merely intended to distinguish between different objects, and shall not be understood as any indication or implication of relative importance or any implicit indication of the number, particular sequence or primary-secondary relationship of the technical features indicated. In the descriptions of the embodiments of the present application, "a plurality of" means two or more, unless otherwise specifically defined.

Reference to "embodiments" in this specification means that particular features, structures, or characteristics described with reference to the embodiments may be included in at least one embodiment of the present application. Occurrence of the phrase in various places in this specification does not necessarily refer to the same embodiment, nor is an independent or alternative embodiment that is mutually exclusive with other embodiments. It is understood explicitly and implicitly by a person skilled in the art that the embodiments described in this specification may be combined with other embodiments.

In the description of the embodiments of the present application, the term "and/or" describes only an association relationship between associated objects and represents that three relationships may exist. For example, A and/or B may represent the following three cases: only A exists, both A and B exist, and only B exists. In addition, the character "/" in this specification generally indicates an "or" relationship between the associated objects.

In the description of embodiments of the present application, the term "a plurality of" means two or more (including two). Similarly, "a plurality of groups" means two or more groups (including two groups), and "a plurality of pieces" means two or more pieces (including two pieces).

In the description of embodiments of the present application, a direction or a positional relationship indicated by the terms such as "center", "longitudinal", "transverse", "length", "width", "thickness", "up", "down", "before", "after", "left", "right", "vertical", "horizontal", "top", "bottom", "in", "out", "clockwise" "counterclockwise", "axial", "radial", and "circumferential" is a direction or positional relationship based on the illustration in the drawings, and is merely intended for ease or brevity of description of embodiments of the present application, but not intended to indicate or imply that the indicated device or component is necessarily located in the specified direction or constructed or operated in the specified direction. Therefore, such terms are not to be understood as a limitation on embodiments of the present application.

In the descriptions of the embodiments of the present application, unless otherwise specified and defined explicitly, the technical terms "mounting", "connection", "join", and "fastening" should be understood in their general senses. For example, they may refer to a fixed connection, a detachable connection, or an integral connection, may refer to a mechanical connection or an electrical connection, and may refer to a direct connection, an indirect connection via an intermediate medium, an internal communication between two elements, or an interaction between two elements. A person of ordinary skill in the art can understand specific meanings of these terms in the embodiments of the present application as appropriate to specific situations.

Currently, the market development trend shows that, power batteries are applied more extensively. The power batteries are not only applied to energy storage power systems such as hydro, thermal, wind, and solar power stations, but also widely applied to electric means of transport such as electric bicycles, electric motorcycles, and electric vehicles, as well as in various fields such as military equipment and aerospace.

The inventor hereof has noticed that the secondary battery can enhance the power endurance of batteries, significantly improve the economic benefits of power storage, and promote the upgrading and transformation of consumer electronics, making itself be of great significance for human life. However, there are still some technical problems with the secondary battery, especially an anode-free lithium metal battery (AFLMB). For example, during the charging and discharging process of a secondary battery, an SEI is formed on the negative electrode side, which consumes a large amount of active lithium, resulting in low first-cycle Coulombic efficiency of the secondary battery.

In order to solve the low first-cycle Coulombic efficiency of the secondary battery, the inventor has conducted in-depth research and found that the research can be carried out from the view of the negative current collector.

The present invention designs a negative current collector and a preparation method thereof, a negative electrode plate, a secondary battery, and an electrical device. A lithium alloy is disposed on a surface of a substrate, and the lithium alloy includes lithium and a matrix material. An atomic ratio of lithium in the lithium alloy is 30% to 50%, and a plating amount of the lithium alloy is 2 g/m² to 3 g/m². During the charging process of a secondary battery, lithium atoms can be oxidized into lithium ions and enter an electrolyte solution to replenish the lithium consumed for forming an SEI on a negative electrode of a lithium-ion battery, which helps to improve the quality of the SEI, thereby improving the first-cycle Coulombic efficiency of the secondary battery.

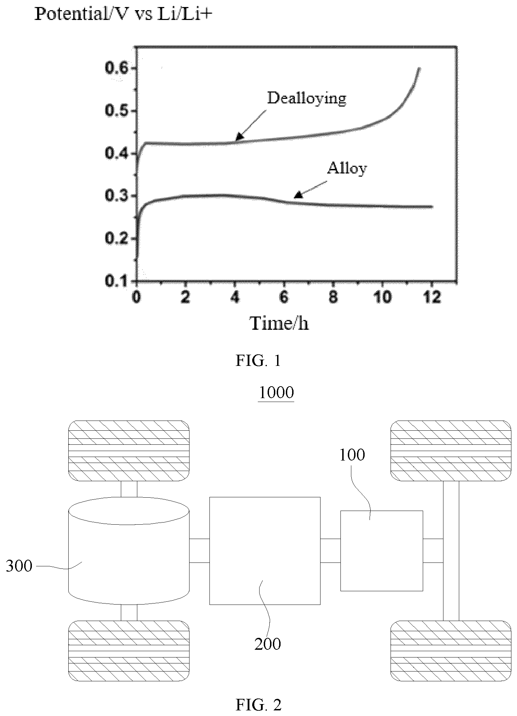

Moreover, referring to FIG. 1, in lithium alloys, alloying-dealloying potentials are higher than Li deposition/stripping potentials, so lithium deposition/stripping is preferentially performed in the alloy state. Therefore, when active lithium is insufficient, lithium in the lithium alloy can be used for lithium supplementation. Moreover, the matrix material left after the lithium alloy is dealloyed can effectively increase the active sites for lithium deposition, reduce the nucleation overpotential of lithium, reduce the local nucleation of lithium, and reduce the formation of lithium dendrites, thereby improving the safety performance of the secondary battery.

At the same time, compared with a pure lithium metal, lithium alloys are more stable in air, which makes the performance of the secondary battery more stable.

Based on the above considerations, in order to solve the technical problem of improving the first-cycle Coulombic efficiency of the secondary battery, the inventor has designed a negative current collector after in-depth research. The negative current collector includes a substrate and a lithium alloy, where the lithium alloy is disposed on a surface of the substrate, the lithium alloy includes lithium and a matrix material, an atomic ratio of lithium in the lithium alloy is 30% to 50%, and a plating amount of the lithium alloy is 2 g/m² to 3 g/m².

The lithium alloy is disposed on the surface of the substrate, the atomic ratio of lithium in the lithium alloy is 30% to 50%, and the plating amount of the lithium alloy is 2 g/m² to 3 g/m², so that during the charging process of the secondary battery, lithium atoms can be oxidized into lithium ions and enter an electrolyte solution to supplement the lithium consumed for forming an SEI on the negative electrode of the lithium-ion battery, which helps to improve the quality of the solid electrolyte interphase SEI, thereby improving the first-cycle Coulombic efficiency of the secondary battery.

Moreover, the matrix material left after the lithium alloy is dealloyed can effectively increase the active sites for lithium deposition, reduce the nucleation overpotential of lithium, reduce the local nucleation of lithium, and reduce the formation of lithium dendrites, therebyimproving the safety performance of the secondary battery.

At the same time, compared with a pure lithium metal, lithium alloys are more stable in air, which makes the performance of the secondary battery more stable.

The negative current collector disclosed in the embodiment of the present application can be applied to a battery cell, and the battery cell can be used in an electrical device that uses a battery as a power source or various energy storage systems that use a battery as an energy storage element. The electrical device can be, but is not limited to, a mobile phone, a tablet, a laptop computer, an electric toy, an electric tool, a battery car, an electric car, a ship, a spacecraft, and the like. Among them, the electric toy can include a fixed or mobile electric toy, for example, a game console, an electric car toy, an electric ship toy, an electric airplane toy, and the like, and the spacecraft can include an airplane, a rocket, a space shuttle, a spacecraft, and the like.

For ease of description in the following embodiments, a vehicle is used as an example of the electrical device 1000 according to an embodiment of the present application.

Referring to FIG. 2, FIG. 2 is a schematic structural diagram of an electrical device 1000 according to some embodiments of the present application. The electrical device 1000 can be an oil-fueled vehicle, a gas vehicle or a new energy vehicle. The new energy vehicle can be a battery electric vehicle, a hybrid electric vehicle or a range-extended vehicle, etc. A battery 100 is disposed inside the electrical device 1000, and the battery 100 can be disposed at the bottom, head or tail of the electrical device 1000. The battery 100 can be configured to supply power to the electrical device 1000. For example, the battery 100 can serve as an operating power source of the electrical device 1000. The electrical device 1000 may also include a controller 200 and a motor 300. The controller 200 is configured to control the battery 100 to supply power to the motor 300, for example, to meet the demand of the electrical device 1000 for the working power during starting, navigating and driving.

In some embodiments of the present application, the battery 100 can serve not only as an operating power source of the electrical device 1000, but also as a driving power source of the electrical device 1000, to provide driving power for the electrical device 1000 in place or partly in place of fuel oil or natural gas.

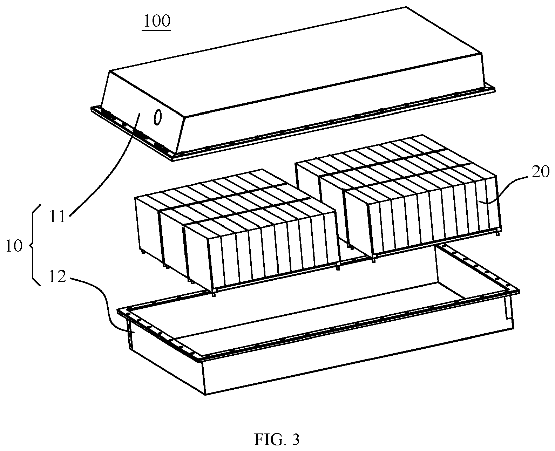

Referring to FIG. 3, FIG. 3 is a schematic exploded view of a battery 100 according to some embodiments of the present application. The battery 100 includes a box 10 and a battery cell 20, and the battery cell 20 is accommodated in the box 10. The box 10 is configured to provide an accommodation space for the battery cell 20, and the box 10 can assume a variety of structures. In some embodiments, the box 10 may include a first portion 11 and a second portion 12, the first portion 11 and the second portion 12 fit and cover each other, and the first portion 11 and the second portion 12 jointly define an accommodation space for accommodating the battery cell 20. The second portion 12 may be a of hollow structure with one end open, and the first portion 11 may be of a platelike structure, and the first portion 11 fits and covers the open side of the second portion 12, so that the first portion 11 and the second portion 12 jointly define the accommodation space; the first portion 11 and the second portion 12 may also be each of a hollow structure with one side open, and the open side of the first portion 11 fits and covers the open side of the second portion 12. Certainly, the box 10 formed by the first portion 11 and the second portion 12 can be in various shapes, such as a cylinder and a cuboid.

In the battery 100, there may be multiple battery cells 20, and the multiple battery cells 20 may be connected in series, in parallel, or in series-and-parallel pattern. The "series-and-parallel pattern" means that there are both series and parallel connections in the multiple battery cells 20. The multiple battery cells 20 may be directly connected in series, in parallel, or in series-and-parallel pattern, and then the whole formed by the multiple battery cells 20 is accommodated in the box 10. Certainly, in the battery 100, the multiple battery cells 20 may first be connected in series or in parallel or in series-and-parallel pattern to form battery modules, and then the multiple battery modules are connected in series or in parallel or in series-and-parallel pattern to form a whole that is accommodated in the box 10. The battery 100 may also include other structures, for example, the battery 100 may also include a busbar component for realizing electrical connection between the multiple battery cells 20.

Each battery cell 20 may be a secondary battery, specifically a lithium-sulfur battery, a lithium-ion battery or a lithium metal battery, which is not limited thereto. The battery cell 20 may be in a shape such as a cylinder, a flat body, a cuboid, or other shapes.

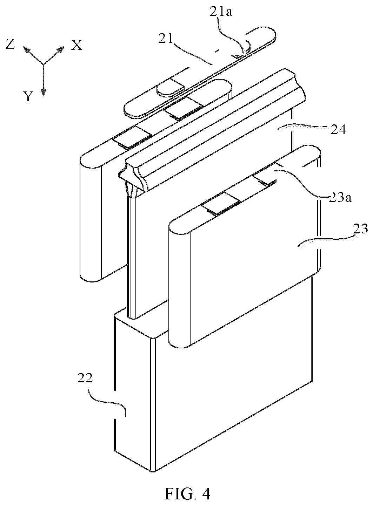

Referring to FIG. 4, FIG. 4 is a schematic exploded view of a battery cell 20 according to some embodiments of the present application. The battery cell 20 refers to a minimum unit that makes up a battery. As shown in FIG. 4, the battery cell 20 includes an end cap 21, a housing 22, a cell assembly 23 and other functional components 24.

The end cap 21 refers to a component that fits and covers an opening of the housing 22 to isolate an internal environment of the battery cell 20 from an external environment. Not restrictively, the shape of the end cap 21 can be adapted to the shape of the housing 22 to fit the housing 22. The end cap 21 can be made of a material with a certain hardness and strength (such as aluminum alloy), so that the end cap 21 is unlikely to deform when subjected to extrusion and collision, allowing the battery cell 20 to have a higher structural strength and improved safety performance. Functional components such as electrode terminals 21a can be disposed on the end cap 21. The electrode terminals 21a can be configured to be electrically connected with the cell assembly 23 to output or input electrical energy of the battery cell 20. In some embodiments, the end cap 21 can also be provided with a pressure relief mechanism for releasing the internal pressure when the internal pressure or temperature of the battery cell 20 reaches a threshold. The end cap 21 can also be made of a variety of materials, such as copper, iron, aluminum, stainless steel, aluminum alloy and plastic, which are not particularly limited in the embodiments of the present application. In some embodiments, an insulator may be disposed on an inner side of the end cap 21, and the insulator may be configured to isolate electrically connected components in the housing 22 from the end cap 21 to reduce the risk of a short circuit. As an example, the insulating member may be plastic, rubber, or the like.

The housing 22 is a component used to fit the end cap 21 to form the internal environment of the battery cell 20, where the formed internal environment can be configured to accommodate the cell assembly 23, the electrolyte solution and other components. The housing 22 and the end cap 21 can be independent components, and an opening can be disposed on the housing 22, and the internal environment of the battery cell 20 is formed by fitting and covering the opening with the end cap 21 at the opening. Not restrictively, the end cap 21 and the housing 22 can also be integrated. Specifically, the end cap 21 and the housing 22 can form a common connection surface before other components are put into the housing, and when the interior of the housing 22 needs to be encapsulated, the end cap 21 is made to fit and cover the housing 22. The housing 22 can be in various shapes and sizes, such as a cuboid, a cylinder, or a hexagonal prism. Specifically, the shape of the housing 22 can be determined according to the specific shape and size of the cell assembly 23. The housing 22 can be made of a variety of materials, such as copper, iron, aluminum, stainless steel, aluminum alloy, or plastic, which are not particularly limited in the embodiment of the present application.

The cell assembly 23 is a component in the battery cell 100 where electrochemical reactions occur. One or more cell assemblies 23 may be included in the housing 22. The cell assembly 23 is mainly formed by winding or stacking a positive electrode plate and a negative electrode plate, and a separator is usually disposed between the positive electrode plate and the negative electrode plate. The parts of the positive electrode plate and the negative electrode plate with active materials make up a body portion of the cell assembly, and the parts of the positive electrode plate and the negative electrode plate without active materials each make up a tab 23a. The positive tab and the negative tab may be located together at one end of the body portion or respectively at both ends of the body portion. During the charging and discharging process of the battery, the positive active material and the negative active material react with the electrolyte solution, and the tabs 23a are connected with the electrode terminals to form a current loop.

According to some embodiments of the present application, the present application provides a negative current collector. The negative current collector includes a substrate and a lithium alloy, where the lithium alloy is disposed on the surface of the substrate, the lithium alloy includes lithium and a matrix material, the atomic ratio of lithium in the lithium alloy is 30% to 50%, and the plating amount of the lithium alloy is 2 g/m² to 3 g/m².

As an example, the substrate has two surfaces opposite to each other in the thickness direction thereof, and the lithium alloy is plated on any one or both of the two opposite surfaces of the substrate. The lithium alloy may form a continuous plating or a discontinuous plating on at least one surface of the substrate.

In some embodiments, the atomic ratio of lithium in the lithium alloy can be 30%, 35%, 38%, 40%, 42%, 45%, 48%, 50%, etc., and can also be 30% to 35%, 35% to 40%, 42% to 45%, 44% to 50%, etc.

In some embodiments, the plating amount of the lithium alloy on the surface of the substrate can be 2.0 g/m², 2.1 g/m², 2.25 g /m², 2.3 g/m², 2.45 g/m², 2.5 g/m², 2.6 g/m², 2.7 g/m², 2.8 g/m², 2.9 g/m², 3.0 g/m², etc., and can also be 2.0 g/m² to 2.25 g/m², 2.3 g/m² to 2.5 g/m², 2.6 g/m² to 3.0 g/m², etc.

The lithium alloy is disposed on the surface of the substrate, the atomic ratio of lithium in the lithium alloy is 30% to 50%, and the plating amount of the lithium alloy is 2 g/m² to 3 g/m², so that during the charging process of the secondary battery, lithium atoms can be oxidized into lithium ions and enter an electrolyte solution to supplement the lithium consumed for forming an SEI on the negative electrode of the lithium-ion battery, which helps to improve the quality of the solid electrolyte interphase SEI, thereby improving the first-cycle Coulombic efficiency of the secondary battery.

Moreover, the matrix material left after the lithium alloy is dealloyed can effectively increase the active sites for lithium deposition, reduce the nucleation overpotential of lithium, reduce the local nucleation of lithium, and reduce the formation of lithium dendrites, therebyimproving the safety performance of the secondary battery.

At the same time, compared with a pure lithium metal, lithium alloys are more stable in air, which makes the performance of the secondary battery more stable.

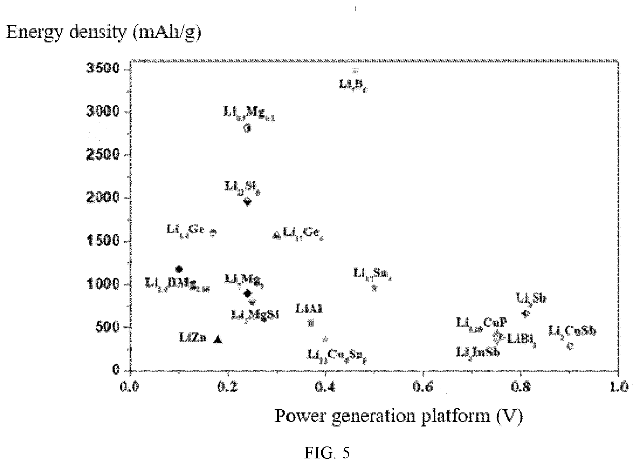

According to some embodiments of the present application, the matrix material includes at least one of Sn, Mg, Zn, Bi, Pb, Au, Ag, Al, and Si. Referring to FIG. 5, FIG. 5 is a schematic diagram of discharge platforms and theoretical energy densities of different lithium alloys.

Sn, Mg, Zn, Bi, Pb, Au, Ag, and Al have good conductivity, which helps to reduce the impedance of the secondary battery and improve the first-cycle Coulombic efficiency of the secondary battery.

At the same time, when the active lithium in the secondary battery is insufficient, the lithium in the lithium alloy is used to supplement the secondary battery. Since Sn, Mg, Zn, Bi, Pb, Au, Ag, Al, and Si all have good lithiophilicity, after the lithium in the lithium alloy enters the electrolyte solution, a matrix material with good lithiophilicity is left, which can effectively increase the active sites for lithium deposition, reduce the nucleation overpotential of lithium, reduce the local nucleation of lithium, and reduce the formation of lithium dendrites, thereby improving the safety performance of the secondary battery.

According to some embodiments of the present application, the matrix material is at least one of Sn, Mg, and Zn.

In the technical solution of the embodiment of the present application, since the matrix materials Sn, Mg, and Zn have a stable structure, the matrix materials are less prone to collapse after delithiation, thereby improving the structural stability of the secondary battery.

According to some embodiments of the present application, the substrate is of a porous structure, the pore size of pores of the porous structure is 5 microns to 500 microns, and the porosity of the pores of the porous structure is 30% to 70%.

In the technical solution of the embodiment of the present application, by adopting a substrate with a porous structure, and setting the pore size and porosity to be within the above ranges, the adhesion of the lithium alloy on the surface of the substrate can be improved, thereby improving the stability of the secondary battery.

At the same time, the porous structure of the substrate also helps to alleviate the volume expansion of lithium.

According to some embodiments of the present application, the substrate is foamed copper or dealloyed porous copper.

In the technical solution of the embodiment of the present application, by using foamed copper or dealloyed porous copper, the adhesion of the lithium alloy on the surface of the substrate can be improved, thereby improving the stability of the secondary battery.

According to some embodiments of the present application, the substrate is a copper foil.

In the technical solution of the embodiment of the present application, a copper foil is used, and the surface of the copper foil is highly smooth and easy to clean, thereby reducing the difficulty of the process.

According to some embodiments of the present application, the present application provides a preparation method of the above-mentioned negative current collector, the method including the following steps:
providing a substrate;
plating a matrix material on a surface of the substrate through a matrix material target, and plating a lithium metal on a surface of the matrix material through a lithium target to form an intermediate product, where an atomic ratio of lithium in the matrix material and the lithium metal is 30% to 50%, and a plating amount of the lithium alloy is 2 g/m² to 3 g/m²; and
conducting heat treatment on the intermediate product to form a lithium alloy from the matrix material and the lithium metal.

According to some embodiments of the present application, the matrix material and lithium are plated on the substrate by ion sputtering, vacuum evaporation, or ion plating, etc.

In the technical solution of the embodiment of the present application, a matrix material is plated on a surface of a substrate through a matrix material target, and a lithium metal is plated on a surface of the matrix material through a lithium target to form an intermediate product, where an atomic ratio of lithium in the matrix material and the lithium metal is 30% to 50%, and a plating amount of the lithium alloy is 2 g/m² to 3 g/m²; and heat treatment is conducted on the intermediate product to form a lithium alloy from the matrix material and the lithium metal, so as to prepare a negative current collector. During the charging process of a secondary battery, lithium atoms can be oxidized into lithium ions and enter an electrolyte solution to supplement the lithium consumed for forming an SEI on a negative electrode of a lithium-ion battery, which helps to improve the quality of the SEI, thereby improving the first-cycle Coulombic efficiency of the secondary battery.

According to some embodiments of the present application, the present application provides a preparation method of the above-mentioned negative current collector, the method including the following steps:
providing a substrate;
plating a lithium alloy on a surface of the substrate through a lithium alloy target, where the lithium alloy includes lithium and a matrix material. An atomic ratio of lithium in the lithium alloy is 30% to 50%, and a plating amount of the lithium alloy is 2 g/m² to 3 g/m².

In some embodiments, the lithium alloy is plated on the substrate by ion sputtering, vacuum evaporation, or ion plating, etc.

In the technical solution of the embodiment of the present application, the lithium alloy is plated on the surface of the substrate through the lithium alloy target, where the lithium alloy includes lithium and a matrix material, the atomic ratio of lithium in the lithium alloy is 30% to 50%, and the plating amount of the lithium alloy is 2 g/m² to 3 g/m², so that a negative current collector is prepared. During the charging process of a secondary battery, lithium atoms can be oxidized into lithium ions and enter an electrolyte solution to supplement the lithium consumed for forming an SEI on a negative electrode of a lithium-ion battery, which helps to improve the quality of the SEI, thereby improving the first-cycle Coulombic efficiency of the secondary battery.

According to some embodiments of the present application, the present application provides a negative electrode plate, and the negative electrode plate includes the negative current collector as described above or the negative current collector prepared by the preparation method of the negative current collector as described above, so as to improve the first-cycle Coulombic efficiency of the secondary battery.

According to some embodiments of the present application, the present application provides a secondary battery, and the secondary battery includes the negative electrode plate as described above, so as to obtain a secondary battery with excellent first-cycle Coulombic efficiency. The secondary battery can be the battery 100 or the battery cell 20 as described above.

The secondary battery includes a positive electrode plate, a negative electrode plate, an electrolyte, and a separator. During the charging and discharging process of the battery, active ions are shuttled between the positive electrode plate and the negative electrode plate by intercalation and deintercalation. The electrolyte serves to conduct ions between the positive electrode plate and the negative electrode plate. The separator is disposed between the positive electrode plate and the negative electrode plate, mainly to prevent short circuits between the positive electrode plate and the negative electrode plate, while allowing ions to pass through.

The positive electrode plate includes a positive current collector and a positive electrode film disposed on the positive current collector. For example, the positive current collector has two surfaces opposite to each other in a thickness direction thereof, and the positive electrode film layer can be disposed on any one or both of the two opposite surfaces of the positive current collector.

The positive electrode film includes a positive active material. The specific type of the positive active material is not subject to specific restrictions and can be selected according to needs. Preferably, the positive active material includes lithium cobalt oxide (LiCoO₂), lithium nickelate (LiNiO₂), lithium iron phosphate (LiFePO₄), lithium cobalt phosphate (LiCoPO₄), lithium manganese phosphate (LiMnPO₄), lithium nickel phosphate (LiNiPO₄), lithium manganese oxide (LiMnO₂), a binary material LiNiₓA₍₁₋ₓ₎O₂ (A is selected from one of Co and Mn, 0 < x < 1), a ternary material LiNiₘBₙC₍₁₋ₘ₋ₙ₎O₂ (B and C are each independently selected from at least one of Co, Al and Mn, and B and C are different, 0 < m < 1, 0 < n < 1), and one or more of modified materials doped and/or coated therein.

The positive electrode film may optionally include a binder. The specific type of the binder is not subject to specific restrictions and can be selected according to needs.

As an example, the binder may include one or more of polyvinylidene fluoride (PVDF), polytetrafluoroethylene (PTFE), polyacrylic acid (PAA), polyvinyl alcohol (PVA), sodium alginate (SA), polymethacrylic acid (PMAA) and carboxymethyl chitosan (CMCS).

The positive electrode film may optionally include a conductive agent. The specific type of the conductive agent is not subject to specific restrictions and can be selected according to needs.

As an example, the conductive agent may include one or more of graphite, superconducting carbon, acetylene black, carbon black, Ketjen black, carbon dots, carbon nanotubes, graphene, and carbon nanofibers.

In some embodiments, the positive electrode film may also optionally include an ion conducting polymer, a lithium salt, and a plasticizer. The ion conducting polymer may be selected from one or more of polyethylene oxide, polyethylene terephthalate, polyimide, polyvinylidene fluoride, polymethyl methacrylate, polyacrylonitrile, polypropylene carbonate, polyvinyl chloride, vinylidene fluoride, 2-acrylamide-2-methylpropanesulfonic acid, trimethylolpropane triacrylate, hyperbranched polyacrylate, and a methyl methacrylate copolymer. The lithium salt may be selected from one or more of lithium hexafluorophosphate (LiPF₆), lithium tetrafluoroborate (LiBF₄), lithium perchlorate (LiClO₄), lithium hexafluoroarsenate (LiAsF₆), lithium bis(fluorosulfonyl)imide (LiFSI), lithium bis(trifluoromethanesulfonyl)imide (LiTFSI), and lithium trifluoromethanesulfonate (LiCF₃SO₃). The plasticizer can be selected from one or more of polyethylene glycol diglycidyl ether (PEGDE), polyethylene glycol diacrylate (PEGDA), polyethylene glycol amine (PEGNH₂), succinonitrile (SN), triethyl phosphate (TEP), fluoroethylene carbonate (TEP), dimethyl ether (DME), diethyl carbonate (DEC), ethylene carbonate (EC), and phthalates.

The electrolyte may be at least one of a liquid electrolyte (i.e., an electrolyte solution) and a solid electrolyte.

In some optional embodiments, the electrolyte is an electrolyte solution, which includes an electrolyte salt and a solvent.

In some embodiments, the electrolyte salt can be selected from one or more of lithium hexafluorophosphate (LiPF₆), lithium tetrafluoroborate (LiBF₄), lithium perchlorate (LiClO₄), lithium hexafluoroarsenate (LiAsF₆), lithium bis(fluorosulfonyl)imide (LiFSI), lithium bis(trifluoromethanesulfonyl)imide (LiTFSI), lithium trifluoromethanesulfonate (LiCF₃SO₃), lithium difluoro(oxalato)borate (LiDFOB), lithium bis(oxalato)borate (LiBOB), lithium difluorophosphate (LiPO₂F₂), lithium difluoro(bisoxalato)phosphate (LiDFOP) and lithium tetrafluoro(oxalato)phosphate (LiTFOP).

In some embodiments, the solvent can be selected from one or more of ethylene carbonate (EC), propylene carbonate (PC), ethyl methyl carbonate (EMC), diethyl carbonate (DEC), dimethyl carbonate (DMC), dipropyl carbonate (DPC), methyl propyl carbonate (MPC), ethylene propyl carbonate (EPC) and butylene carbonate (BC).

In some preferred embodiments, the electrolyte includes a solid electrolyte. The solid electrolyte is usually disposed between a negative electrode plate and a positive electrode plate in the form of a solid electrolyte film. The solid electrolyte film can be selected from one or more of an inorganic solid electrolyte film, a solid polymer electrolyte film and an inorganic-organic composite solid electrolyte film. The use of a solid electrolyte film is conducive to reducing the thickness of the battery, and there is no risk of leakage compared to an electrolyte solution. In these embodiments, the secondary battery is an all-solid-state battery or a semi-solid-state battery.

The negative current collector in the secondary battery includes a substrate and a lithium alloy, where the lithium alloy is disposed on the surface of the substrate, and the lithium alloy includes lithium and a matrix material, the atomic ratio of lithium in the lithium alloy is 30% to 50%, and the plating amount of the lithium alloy is 2 g/m² to 3 g/m². During the charging process of the secondary battery, the lithium atoms can be oxidized into lithium ions and enter the electrolyte solution to supplement the lithium consumed for forming an SEI on the negative electrode of the lithium-ion battery, which helps to improve the quality of the SEI, thereby improving the first-cycle Coulombic efficiency of the secondary battery.

Moreover, the matrix material left after the lithium alloy is dealloyed can effectively increase the active sites for lithium deposition, reduce the nucleation overpotential of lithium, reduce the local nucleation of lithium, and reduce the formation of lithium dendrites, therebyimproving the safety performance of the secondary battery.

At the same time, compared with a pure lithium metal, lithium alloys are more stable in air, which makes the performance of the secondary battery more stable.

According to some embodiments of the present application, the present application provides an electrical device. The electrical device includes a secondary battery provided by any of the above solutions, and the battery is configured to provide electrical energy for the electrical device.

The electrical device may be any of the aforementioned devices or systems that apply the secondary battery.

The preparation process and test data are introduced as follows:

### Embodiment 1:

In this embodiment, the substrate of the negative current collector is a commercially available foamed copper with a thickness of 171 µm, a porosity of 72%, and an average pore diameter of 165 µm. The target material is a commercially available lithium alloy target material, i.e., a cylindrical target with a specification of Φ51*2 mm, and the atomic ratio of Sn to Li in the lithium alloy target material is (Sn:Li) = 8:2.

A PVD-Li₂Sn₈ sample was prepared in a vacuum magnetron sputtering device, and the upper limit of the pressure of the vacuum magnetron sputtering device was set to 0.8 MPa. A quartz microbalance was disposed under the substrate in the chamber. After sputtering was started, the sputtering amount was controlled by measuring the weight of the substrate. A plating with a plating amount of 2.5 g/m² was plated on the surface of the negative current collector using the Li₂Sn₈ target material.

### Embodiments 2-7:

Embodiments 2-7 are basically the same as Embodiment 1, and the only difference lies in that: the atomic ratio of Sn to Li (Sn:Li) in the lithium alloy target is different, as shown in Table 1.

### Embodiment 8-10:

Embodiments 8-10 are basically the same as Embodiment 1, and the only difference lies in that: the plating amount of the lithium-containing alloy target material on the surface of the negative current collector is different, as shown in Table 1.

### Comparative Embodiment 1:

The sample is blank foamed copper.

### Comparative Embodiment 2:

A pure Sn target was used as the target material, and the plating amount was 2.5 g/m².

### Comparative Embodiment 3:

A pure Sn target and a pure Li target were used as the target materials, and the total plating amount was 2.5 g/m². Sn with an atomic ratio of 60% was firstly plated, and then Li with an atomic ratio of 40% was plated.

The following gives an introduction to assembly of the negative current collectors in Embodiments 1-10 and Comparative Embodiments 1-3 into button-type half batteries and full batteries, respectively, and the performance testing thereof.

Assembly of negative current collectors in Embodiments 1-10 and Comparative Embodiments 1-3 / Li into half-batteries and performance testing thereof:.

Negative current collectors in Embodiments 1-10 and Comparative Embodiments 1-3 were used for the negative electrode, respectively, a lithium sheet was used as the negative electrode, a solution of 1 M LiFSI dissolved in DME was used as the electrolyte solution, and a 12 µm PE film was used as the separator used, so that button-type negative current collectors/Li half batteries were assembled respectively.

Discharging conditions: The half batteries assembled above were discharged at a constant current at a room temperature with a current density of 1 mA / cm², and the discharge was continued until a short circuit signal appeared, that is, the battery voltage jumped to 0 V.

The time from the start of discharge to the short circuit was recorded.

Assembly of lithium iron phosphate LFP/negative current collectors in Embodiments 1-10 and Comparative Embodiments 1-3 into full batteries and performance testing thereof:

Lithium iron phosphate was used as the positive electrode, where the ratio of lithium iron phosphate to conductive carbon black to PVDF binder is 8:1:1; the lithium alloy-plated negative current collector obtained in Embodiments 1-10 and the negative current collector obtained in Comparative Embodiments 1-3 were used as the negative electrode; a solution of 1 M LiFSI dissolved in DME was used as the electrolyte solution; and a 12 µm PE film was used as the separator used, so that full batteries were assembled separately.

Charging conditions: The full batteries were charged at a room temperature in a constant current-constant voltage mode (CC-CV mode). First, the battery was charged at a fixed rate of 0.2 C in the constant current mode until the voltage raised to 3.65 V, and then charged in the constant voltage mode until the current dropped to 0.05 C to fully charge the full battery to saturation.

Discharging conditions: The battery was discharged at a discharge rate of 0.5 C in a constant current mode until the voltage dropped to 2 V, and 200 cycles were conducted.

The number of cycles at which the discharge capacity retention rate of the full battery is 50% was recorded.

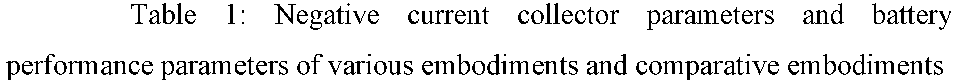

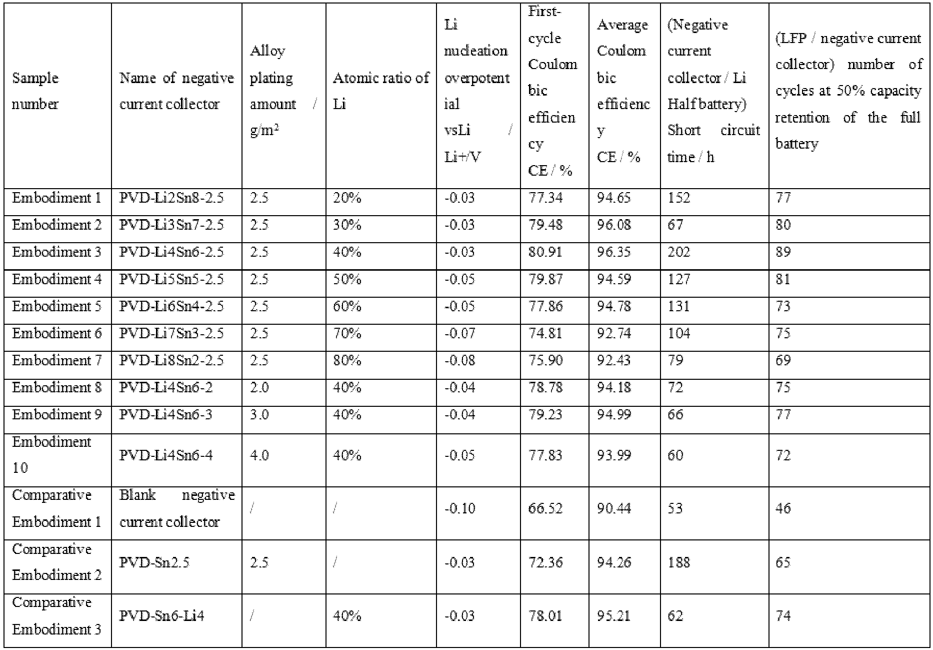

In Table 1, the comparison of results of Embodiments 1-10 and Comparative Embodiment 1 shows that the use of the negative current collector containing a lithium alloy as the negative current collector of the secondary battery can effectively reduce the Li nucleation overpotential and improve the first-cycle Coulombic efficiency and average coulombic efficiency of the secondary battery.

In Table 1, the comparison of results of Embodiments 1-10 and Comparative Embodiment 2 shows that compared with the negative current collector plated with only the matrix material, the negative current collector is plated with a lithium alloy, which improves the first-cycle Coulombic efficiency of the secondary battery by 2% to 8% due to the addition of Li, and also improves the average coulombic efficiency and cycle performance.

In Table 1, the comparison of results of Embodiment 3 and Embodiments 1-2 and 4-7 shows that the use of a lithium-containing alloy with an atomic ratio of Li of 40% has the strongest effect on improving the first-cycle Coulombic efficiency and cycle performance of the secondary battery.

In Table 1, the comparison of results of Embodiment 3 and Embodiments 8-10 shows that when the atomic ratio of Li in the lithium alloy is the same, as the plating amount of the lithium-containing alloy increases, the first-cycle Coulombic efficiency of the secondary battery is also improved. When the plating amount of the lithium-containing alloy is 2.5 g/m², the first-cycle Coulombic efficiency reaches the maximum value. After the plating amount of the lithium-containing alloy reaches 2.5 g/m², the first-cycle Coulombic efficiency of the secondary battery is no longer improved when the plating amount is further increased.

In Table 1, the comparison of results of Embodiment 3 and Comparative Embodiment 3 shows that the first-cycle Coulombic efficiency and cycle performance of the secondary battery obtained by directly plating the lithium alloy are better than those of the secondary battery obtained by first plating Sn and then plating Li.

Based on the test results in Table 1, it can be concluded that Embodiment 3 is the best embodiment, where the atomic ratio of lithium in the lithium alloy is 40%, and the plating amount of the lithium alloy on the surface of the substrate is 2.5 g/m².

As can be seen from the comparison between the above embodiments and the comparative embodiments, by disposing a lithium alloy on the surface of a substrate, and setting the atomic ratio of lithium in the lithium alloy to be 30% to 50%, and the plating amount of the lithium alloy to be 2 g/m² to 3 g/m², during the charging process of the secondary battery, the lithium atoms can be oxidized into lithium ions and enter the electrolyte solution to supplement the lithium consumed for forming an SEI on the negative electrode of the lithium-ion battery, which helps to improve the quality of the SEI, thereby improving the first-cycle Coulombic efficiency of the secondary battery.

Although the present application has been described with reference to preferred embodiments, various improvements may be made thereto and components thereof may be replaced with equivalents without departing from the scope of the present application. Particularly, technical features mentioned in the embodiments may be combined in any manner as long as there is no structural conflict. the present application is not limited to the specific embodiments disclosed in this specification, but includes all technical solutions falling within the scope of the claims.

## Claims

1. A negative current collector, comprising a substrate and a lithium alloy, wherein the lithium alloy is disposed on a surface of the substrate, and the lithium alloy comprises lithium and a matrix material, an atomic ratio of lithium in the lithium alloy is 30% to 50%, and a plating amount of the lithium alloy is 2 g/m² to 3 g/m².

2. The negative current collector according to claim 1, wherein the matrix material comprises at least one of Sn, Mg, Zn, Bi, Pb, Au, Ag, Al, and Si.

3. The negative current collector according to claim 1, wherein the matrix material is at least one of Sn, Mg, and Zn.

4. The negative current collector according to any one of claims 1 to 3, wherein the substrate is of a porous structure, a pore size of pores of the porous structure is 5 microns to 500 microns, and a porosity of the pores of the porous structure is 30% to 70%.

5. The negative current collector according to any one of claims 1 to 4, wherein the substrate is foamed copper or dealloyed porous copper.

6. The negative current collector according to any one of claims 1 to 3, wherein the substrate is a copper foil.

7. A preparation method of the negative current collector according to any one of claims 1 to 6, comprising the following steps:
providing a substrate;
plating a matrix material on a surface of the substrate through a matrix material target, and plating a lithium metal on a surface of the matrix material through a lithium target to form an intermediate product, wherein an atomic ratio of lithium in the matrix material and the lithium metal is 30% to 50%, and a plating amount of the lithium alloy is 2 g/m² to 3 g/m²; and
conducting heat treatment on the intermediate product to form a lithium alloy from the matrix material and the lithium metal.

8. A preparation method of the negative current collector according to any one of claims 1 to 6, comprising the following steps:
providing a substrate;
plating a lithium alloy on a surface of the substrate through a lithium alloy target, wherein the lithium alloy comprises lithium and a matrix material, an atomic ratio of lithium in the lithium alloy is 30% to 50%, and a plating amount of the lithium alloy is 2 g/m² to 3 g/m².

9. A negative electrode plate, comprising the negative current collector according to any one of claims 1 to 6 or the negative current collector prepared by the preparation method of the negative current collector according to claim 7 or 8.

10. A secondary battery, comprising the negative electrode plate according to claim 9.

11. An electrical device, comprising the secondary battery according to claim 10.
